# EUROPEAN PATENT APPLICATION

(11) **EP 3 162 873 A1**
(43) Date of publication of application: **03.05.2017**
(21) Application number: 15815835.2
(22) Date of filing: 29.06.2015
(51) Int. Cl.: C09K 11/08, C09K 11/59, H01L 33/50

(54) **PRODUCTION METHOD FOR SURFACE-TREATED PHOSPHOR, SURFACE-TREATED PHOSPHOR, WAVELENGTH CONVERSION MEMBER, AND LIGHT EMITTING DEVICE**

(30) Priority: 30.06.2014 JP 2014133549
(71) Applicant: Panasonic Intellectual Property Management Co., Ltd., Osaka-shi, Osaka 540-6207 (JP)
(72) Inventor: SHIBAMOTO, Shinji, Chuo-ku Osaka-shi Osaka 540-6207 (JP); OSHIO, Shozo, Chuo-ku Osaka-shi Osaka 540-6207 (JP); YAMAZAKI, Keiichi, Chuo-ku Osaka-shi Osaka 540-6207 (JP); MIYAZAKI, Emi, Chuo-ku Osaka-shi Osaka 540-6207 (JP); WEN, Di, Chuo-ku Osaka-shi Osaka 540-6207 (JP)
(74) Representative: Müller-Boré & Partner Patentanwälte PartG mbB
(86) International application number: PCT/JP2015/003241
(87) International publication number: WO 2016/002185

(57) **Abstract**

A method of manufacturing a surface-treated phosphor (11) in which the surface of an alkaline-earth silicate phosphor (12) containing a silicate of alkaline-earth metal is covered with a surface treatment layer (13), the method comprising: surface treatment which brings the alkaline-earth silicate phosphor (12) and a surface treatment substance into contact in the presence of at least a kind of polyol selected from the group of diols and triols to form the surface treatment layer (13) on the surface of the alkaline-earth silicate phosphor (12), the surface treatment substance being at least one selected from the group consisting of a sulfate, a phosphate, a carbonate, a borate, a boric acid, a titanate, and a fluoride.

## Description

### TECHNICAL FIELD

The disclosure relates to a method of manufacturing a surface-treated phosphor in which the surface of an alkaline-earth silicate phosphor is covered with a surface treatment layer, a surface-treated phosphor obtained by the method, a wavelength conversion member including the same, and a light emission device including the same.

### BACKGROUND ART

Alkaline-earth silicate phosphors such as (Sr,Ba,Ca)₂SO₄:Eu²⁺, for example, have attracted attention as a phosphor for white LEDs because light with various wavelengths is easily obtained with the alkaline-earth silicate phosphors by controlling the composition thereof and the alkaline-earth silicate phosphors have high luminous efficiency.

However, alkaline-earth silicate phosphors generally have low moisture resistance. Specifically, in the presence of water or moisture in the air, alkaline-earth metal reacts with water to produce hydroxides in the surface of the alkaline-earth silicate phosphor. The production of hydroxides deteriorates the alkaline-earth silicate phosphor, reducing the luminous efficiency. Some techniques have been proposed to form a surface treatment layer resistant to moisture on the surface of alkaline-earth silicate phosphor.

For example, a manufacturing method is proposed which brings an alkaline-earth silicate phosphor into contact with a surface treatment solution containing a water-soluble compound such as a sulfate to form a surface treatment layer on the surface of the alkaline-earth silicate phosphor (Patent Literature 1, for example).

### CITATION LIST

### PATENT LITERATURE

Patent Literature 1: Japanese Unexamined Patent Application Publication No. 2013-40236

### SUMMARY OF INVENTION

A method of manufacturing a surface-treated phosphor of the disclosure is the method of manufacturing a surface-treated phosphor in which the surface of an alkaline-earth silicate phosphor containing a silicate of alkaline-earth metal is covered with a surface treatment layer. The method of manufacturing a surface-treated phosphor includes surface treatment which brings the alkaline-earth silicate phosphor and a surface treatment substance into contact in the presence of at least a kind of polyol selected from the group of diols and triols to form the surface treatment layer on the surface of the alkaline-earth silicate phosphor. Herein, the surface treatment substance is at least one selected from the group consisting of a sulfate, a phosphate, a carbonate, a borate, a boric acid, a titanate, and a fluoride.

With the aforementioned configuration, it is possible to manufacture a surface-treated phosphor with high initial luminous efficiency and high long-term reliability. The surface-treated phosphor of the disclosure and a wavelength conversion member and a light emission device which include the same surface-treated phosphor have high initial luminous efficiency and high long-term reliability.

### BRIEF DESCRIPTION OF DRAWINGS

[FIG. 1] FIG. 1 is a schematic diagram illustrating a surface-treated phosphor and a wavelength conversion member according to an embodiment of the disclosure.
[FIG. 2] FIG. 2 is a perspective view of a semiconductor light emission device according to the embodiment of the disclosure.
[FIG. 3A] FIG. 3A is a cross-sectional view taken along a line 3A-3A in FIG. 2.
[FIG. 3B] FIG. 3B is a cross-sectional view taken along a line 3B-3B in FIG. 2.
[FIG. 4] FIG. 4 is a view for explaining a method of forming a sealing member in the semiconductor light emission device illustrated in FIG. 2.

### DESCRIPTION OF EMBODIMENT

Prior to an embodiment of the disclosure, a description is given of problems in relevant methods to manufacture a surface-treated phosphor.

At forming the surface treatment layer by the method of Patent Literature 1, the alkaline-earth silicate phosphor comes into contact with a surface treatment solution. The surface of the alkaline-earth silicate phosphor reacts with water to form a hydroxide before the surface treatment layer is formed. This reduces the initial luminous efficiency of the surface-treated phosphor obtained by the manufacturing method of Patent Literature 1.

With the method of Patent Literature 1, even when the surface treatment layer is formed, water derived from the surface treatment solution remains between the surface of the alkaline-earth silicate phosphor and the surface treatment layer. The remaining water gradually deteriorates the surface of the alkaline-earth silicate phosphor over a long period of time. This also reduces the luminous efficiency gradually, that is, degrades the long-term reliability.

In the surface-treated phosphor obtained by the method of Patent Literature 1, the remaining water could deteriorate the surface treatment layer.

Hereinafter, a description is given of the method of manufacturing a surface-treated phosphor according to the embodiment of the disclosure, the surface-treated phosphor obtained by the same method, and a wavelength conversion member and a light emission device including the same in detail.

### [Method of Manufacturing Surface-treated Phosphor]

A method of manufacturing a surface-treated phosphor according to the embodiment is a method of manufacturing a surface-treated phosphor including: an alkaline-earth silicate phosphor composed of a silicate of alkaline-earth metal; and a surface treatment layer covering the surface of the alkaline-earth silicate phosphor. The method of manufacturing a surface-treated phosphor according to the embodiment includes a surface treatment step below.

### (Surface Treatment Step)

The surface treatment step is a step of bringing the alkaline-earth silicate phosphor into contact with a surface treatment substance which is at least one selected from a group of a sulfate, a phosphate, a carbonate, a borate, a boric acid, a titanate, and a fluoride. Specifically, the surface treatment step is a step of bringing the alkaline-earth silicate phosphor into contact with the surface treatment substance in the presence of at least one type of polyol selected from the group consisting of diols and triols. At first, the alkaline-earth silicate phosphor, surface treatment substance, and polyol used in the step are described.

### <Alkaline-earth Silicate Phosphor>

The alkaline-earth silicate phosphor used in the embodiment contains a silicate of alkaline-earth metal. The alkaline-earth silicate phosphor contains a silicate of alkaline-earth metal as a crystalline matrix of the phosphor and a substance other than the silicate of alkaline-earth metal, such as an activator agent.

In the silicate of alkaline-earth metal, the alkaline-earth metal is at least one selected from the group consisting of strontium, barium, and calcium, for example.

In the silicate of alkaline-earth metal, specifically, the crystalline structure of the matrix is the substantially same as the crystalline structure of M₃SiO₅ of M₂SiO₄, for example. Herein, M is at least a kind of alkaline-earth metal selected from a group consisting of Sr, Ba, and Ca, for example. The structure substantially same as the crystalline structure of M₃SiO₅ of M₂SiO₄ means that X-ray diffraction measurement of the silicate of alkaline-earth metal results in an X-ray diffraction pattern similar to M₃SiO₅ of M₂SiO₄.

The activator agent contained in the alkaline-earth silicate phosphor is at least one element selected from a group consisting of Fe, Mn, Cr, Bi, Ce, Pr, Nd, Sm, Eu, Tb, Dy, Ho, Er, Tm, and Yb, for example.

The alkaline-earth silicate phosphor may contain a metal element such as Zn, Ga, Al, Y, Gd, or Tb, a halogen element such as F, Cl, or Br, sulfur (S), or phosphorous (P), for example, if necessary. The alkaline-earth silicate phosphor may contain one or two or more of these elements.

Examples of the alkaline-earth silicate phosphor include an orange phosphor having a composition expressed by general formula (1), an orange phosphor having a composition expressed by general formula (2), a green or yellow phosphor having a composition expressed by general formula (3), and a green or yellow phosphor having a composition expressed by general formula (4).

(Sr₁₋ₓMₓ)_{y}SiO₅:Eu²⁺ ... (1)

In formula (1), M is at least a kind of metal selected from the group consisting of Ba and Ca. In formula (1), 0 ≤ x < 1.0, and 2.6 ≤ y ≤ 3.3.

(Sr₁₋ₓMₓ)ySiO₅:Eu²⁺D ... (2)

In formula (2), M is at least a kind of metal selected from a group consisting of Ba and Ca. D is a halogen anion selected from a group consisting of F, Cl, and Br. In formula (2), 0 ≤ x < 1.0, and 2.6 ≤ y ≤ 3.3.

(Sr₁₋ₓMₓ)_{y}SiO₄:Eu²⁺ ... (3)

In formula (3), M is at least a kind of metal selected from a group consisting of Ba and Ca. In formula (3), 0 ≤ x < 1.0, and 1.8 ≤ y ≤ 2.2.

(Sr₁₋ₓMₓ)_{y}SiO₄:Eu²⁺D ... (4)

In formula (4), M is at least a kind of metal selected from a group consisting of Ba and Ca. D is a halogen anion selected from a group consisting of F, Cl, and Br. In formula (4), 0 ≤ x < 1.0, and 1.8 ≤ y ≤ 2.2.

The alkaline-earth silicate phosphor normally has a reffractive index of 1.8 to 1.9.

Externally, the alkaline-earth silicate phosphor normally takes a granular form. The average particle diameter of the alkaline-earth silicate phosphor is not less than 1 µm, preferably not less than 5 µm, and more preferably not less than 8 µm and not more than 50 µm. Herein, the average particle diameter refers to median diameter (D₅₀). The average particle diameter is obtained using a laser diffraction scattering method with a laser diffraction-type particle size distribution measurement apparatus. The average particle diameter can be also calculated by microscopic observation with an SEM or the like.

When the alkaline-earth silicate phosphor has a large average particle diameter, the low defect density in the alkaline-earth silicate phosphor particles reduces the energy loss at light emission, increasing the luminous efficiency. When the average particle diameter of the alkaline-earth silicate phosphor is less than 1 µm, the alkaline-earth silicate phosphor is more likely to have low luminance. Moreover, the alkaline-earth silicate phosphor is subject to aggregation, creating difficulties in uniform coating. When the alkaline-earth silicate phosphor has an average particle diameter within the aforementioned range, therefore, the energy loss at light emission is reduced, the luminous efficiency is increased, and uniform coating is easily attained.

When the average particle diameter of the alkaline-earth silicate phosphor is too large, the resultant surface-treated phosphor disperses less within a translucent medium, adversely affecting the properties of the wavelength conversion member and light emission device. When the surface-treated phosphor is strictly required to have dispersibility, therefore, the practical upper limit of the average particle diameter of the alkaline-earth silicate phosphor is set to 50 µm as described above.

### <Surface Treatment Substance>

The surface treatment substance used in the embodiment is a raw material constituting a surface treatment layer that covers the surface of the alkaline-earth silicate phosphor.

The surface treatment substance used in the embodiment is at least one selected from a group consisting of a sulfate, a phosphate, a carbonate, a borate, a boric acid, a titanate, and a fluoride.

Examples of the sulfate include ammonium sulfate, ammonium hydrogen sulfate, sodium sulfate, potassium sulfate, lithium sulfate, aluminum sulfate, aluminum sodium sulfate, and ammonium sodium sulfate.

Examples of the phosphate include ammonium hydrogen phosphate, ammonium dihydrogen phosphate, sodium hydrogen phosphate, potassium hydrogen phosphate, ammonium sodium phosphate, and ammonium potassium phosphate.

Examples of the carbonate include ammonium carbonate, ammonium hydrogen carbonate, sodium carbonate, sodium hydrogen carbonate, potassium carbonate, and potassium hydrogen carbonate.

Examples of the borate include sodium metaborate (NaBO₂). In this embodiment, the surface treatment substance can be a boric acid as well as the borate.

Examples of the titanate include titanium alkoxide and titanium complex.

Examples of the fluoride include ammonium fluoride (NH₄F), ammonium bifluoride (NH₄HF₂), sodium fluoride (NaF), and potassium fluoride (KF).

These surface treatment substances dissolve in polyol to generate anions. The mechanism how the surface treatment substance dissolves in polyol is considered to be due to complexation of polyol that complexes the surface treatment substance. In the surface of the alkaline-earth silicate phosphor with which the surface treatment substance will come into contact, there are normally Sr(OH)₂, Ba(OH)₂, Ca(OH)₂, or the like, which are hydroxides of strontium, barium, calcium, and the like, respectively, due to reaction with moisture in the air or the like. When the anions produced from the surface treatment substance and the alkaline-earth metal hydroxide in the surface of the alkaline-earth silicate phosphor come into contact and react with each other, therefore, the surface treatment layer composed of an alkaline-earth metal salt is formed on the surface of the alkaline-earth silicate phosphor. The alkaline-earth metal salt is poorly soluble in water, and the surface treatment layer is therefore resistant to water.

A description is given of the mechanism of generating the surface treatment layer when the surface treatment substance is ammonium sulfate. When ammonium sulfate is put into polyol, the ammonium sulfate dissolves in the polyol due to complexation of the polyol or the like, so that sulfate ions are generated in the polyol. When the generated sulfate ions come into contact with Sr(OH)₂, Ba(OH)₂, Ca(OH)₂, or the like, which are alkaline-earth metal hydroxides in the surface of the alkaline-earth silicate phosphor, within the polyol, reactions expressed by formulae (5) to (7) are produced. This results in formation of the surface treatment layer composed of SrSO₄, BaSO₄, CaSO₄, or the like, which are poorly soluble sulfates, in the alkaline-earth silicate phosphor.

Sr(OH)₂ + SO₄²⁻ → SrO₄ + 2OH⁻ ... (5)

Ba(OH)₂ + SO₄²⁻ → BaSO₄ + 2OH⁻ ... (6)

Ca(OH)₂ + SO₄²⁻ → CaSO₄ + 2OH⁻ ... (7)

The mechanism of producing the poorly soluble sulfate from the sulfate dissolved in the polyol is considered to be similarly applied to the phosphate, carbonate, borate, boric acid, titanate, and fluoride, which are the surface treatment substances other than the sulfate.

Specifically, the phosphate, carbonate, borate, boric acid, titanate, and fluoride dissolve in polyol due to complexation of the polyol or the like to generate phosphate ions, carbonate ions, borate ions, titanate ions, and fluoride ions, respectively. When the generated phosphate ions, carbonate ions, borate ions, titanate ions, and fluoride ions come into contact with the alkaline-earth metal hydroxide in the surface of the alkaline-earth silicate phosphor, the surface treatment layer composed of a poorly soluble salt is formed.

A description is given of the case where the surface treatment substance is ammonium carbonate as an example. When the carbonate ions generated from the ammonium carbonate in the polyol come into contact with Sr(OH)₂, Ba(OH)2, Ca(OH)₂, or the like, which are alkaline-earth metal hydroxides in the surface of the alkaline-earth silicate phosphor, reactions expressed by the following formulae (8) to (10) are caused. These reactions result in formation of the surface treatment layer composed of SrCO₃, BaCO₃, CaCO₃, or the like, which are poorly soluble carbonates, in the surface of the alkaline-earth silicate phosphor.

Sr(OH)₂ + CO₃²⁻ → SrCO₃ + 2OH⁻ ... (8)

Ba(OH)₂ + CO₃²⁻ → BaCO₃ + 2OH⁻ ... (9)

Ca(OH)₂ + CO₃²⁻ → CaCO₃ + 2OH⁻ ... (10)

### <Polyol>

The polyol used in the embodiment is provided as a solvent or a dispersion medium of the alkaline-earth silicate phosphor and surface treatment substance in the process of bringing the alkaline-earth silicate phosphor and surface treatment substance into contact. The surface treatment substance is soluble in the polyol. Accordingly, it is possible to form the surface treatment layer on the surface of the alkaline-earth silicate phosphor without bringing the alkaline earth silicate phosphor into contact with water.

The polyol used in the embodiment is at least one selected from the group consisting of diols and triols. Examples of the diols include ethylene glycol and derivatives thereof. Examples of triols include glycerin and derivatives thereof The derivatives refer to diols and triols with a functional group introduced without significantly changing the structure and properties of the matrix thereof. Among ethylene glycol and derivatives and glycerin and derivative thereof, ethylene glycol and derivatives thereof are preferred because ethylene glycol and derivatives thereof have a comparatively low viscosity and a low boiling point and can be removed by drying.

The surface treatment substance used in the embodiment is difficult to dissolve in monohydroxy alcohol, such as methanol, ethanol, or isopropanol, which are commonly used solvents. The surface treatment layer is therefore difficult to form in a non-aqueous solvent composed of only monohydroxy alcohol. On the other hand, the surface treatment substance is soluble in polyol used in the embodiment. The surface treatment layer can be formed on the surface of the alkaline-earth silicate phosphor within polyol or non-aqueous solvent containing polyol.

In the surface treatment step, the alkaline-earth silicate phosphor and surface treatment substance are brought into contact with each other in the presence of polyol. The sentence "the alkaline-earth silicate phosphor and surface treatment substance are brought into contact with each other in the presence of polyol" means that the alkaline-earth silicate phosphor and surface treatment substance are brought into contact with each other within a solvent containing polyol. The solvent containing polyol means polyol or a solvent containing polyol. In the solvent containing polyol, the solvent contained in addition to polyol is a solvent other than water and is monohydroxy alcohol such as methanol, ethanol, or isopropanol, for example. These solvents can be used alone or in combination.

The solvent containing polyol substantially does not contain water. The sentence "the solvent substantially does not contain water" means "water is not actively added to the solvent". The state of the solvent containing polyol which has absorbed a very small amount of moisture in the air is included in the state of the solvent substantially not containing the solvent. When the solvent containing polyol is composed of only polyol, the alkaline-earth silicate phosphor and surface treatment substance are less likely to come into contact with moisture. It is therefore preferable for the solvent containing polyol to be composed of only polyol.

The concentration of polyol in the solvent containing polyol is normally not less than 90 mass%, preferably not less than 95 mass%, and more preferably not less than 98 mass%. When the concentration of polyol is higher, the alkaline-earth silicate phosphor and surface treatment layer is less subject to deterioration due to moisture. It is therefore preferable for the concentration of polyol to be higher.

In the step, the alkaline-earth silicate phosphor is brought into contact with the surface treatment substance which is dissolved in the solvent containing polyol. In an example of the method of dissolving the surface treatment substance in the solvent containing polyol, the surface treatment substance is dissolved in the solvent containing polyol, and then the alkaline-earth silicate phosphor is added to the solvent which is being stirred. Alternatively, a solution in which the surface treatment substance is dissolved in the solvent containing polyol and a dispersion solution in which the alkaline-earth silicate phosphor is dispersed in the solvent containing polyol are stirred and mixed. Among these two methods, the latter method is preferred because the alkaline-earth silicate phosphor evenly dispersed in the polyol and the dissolved surface treatment substance are likely to react uniformly. In the case of employing the latter method, the surface treatment step normally includes plural sub-steps. Hereinafter, these sub-steps are described. The surface treatment step includes a dispersion solution preparation step, a surface treatment substance-dissolved solution preparation step, and a mixing step.

### <Dispersion Solution Preparation Step>

In the dispersion solution preparation step, the alkaline-earth silicate phosphor is dispersed in the solvent containing polyol to produce a phosphor dispersion solution (A). The solvent containing polyol is as described above. The dispersion solution preparation step provides the phosphor dispersion solution (A), in which the alkaline-earth silicate phosphor is dispersed in the solvent containing polyol. The phosphor dispersion solution (A) is at an ordinary temperature of 5 to 35°C, for example.

### <Surface Treatment Substance-dissolved Solution Preparation Step>

In the surface treatment substance-dissolved solution preparation step, the surface treatment substance is dissolved in the solvent containing polyol to produce a surface treatment substance-dissolved solution (B). The solvent containing polyol is as described above. The surface treatment substance-dissolved solution preparation step provides the surface treatment substance-dissolved solution (B), in which the surface treatment substance is dissolved in the solvent containing polyol. The surface treatment substance-dissolved solution (B) is at an ordinary temperature of about 5 to 35°C, for example.

<Mixing Step>

In the mixing step, the phosphor dispersion solution (A) and surface treatment substance-dissolved solution (B) are mixed. In the mixing step, by mixing the phosphor dispersion solution (A) and surface treatment substance-dissolved solution (B), a slurry (C) is obtained which includes the alkaline-earth silicate phosphor and dissolved surface treatment substance in the solvent containing polyol. The mixing method is stirring using a magnetic stirrer, for example.

In the mixing step, the temperature of the slurry (C) obtained by mixing the phosphor dispersion solution (A) and surface treatment substance-dissolved solution (B) is an ordinary temperature of about 5 to 35°C, for example. In this temperature range, the alkaline-earth silicate and dissolved surface treatment substance react with each other well.

When the slurry (C) continues to be stirred, the alkaline-earth silicate and dissolved surface treatment substance react with each other sufficiently. Accordingly, a surface-treated phosphor in which the surface treatment layer is formed on the surface of the alkaline-earth silicate phosphor is produced within the solvent containing polyol.

In the stirring of the slurry (C), it is preferable to continue to stir the slurry (C) until the thickness of the surface treatment layer on the surface of the alkaline-earth silicate phosphor becomes normally not less than 5 mm and not more than 1000 nm, preferably not less than 10 nm and not more than 500 nm, more preferably not less than 20 nm and not more than 500 nm, and still more preferably not less than 40 nm and not more than 200 nm.

When the thickness of the surface treatment layer is not less than 5 nm, the alkaline-earth silicate phosphor is covered with the surface treatment layer with a substantially uniform thickness even if particles of the alkaline-earth silicate phosphor have rough surfaces. It is therefore preferable for the thickness of the surface treatment layer to be not less than 5 nm. When the thickness of the surface treatment layer is not more than 1000 nm, the surface treatment layer is less likely to be cracked and is therefore prevented from being peeled off. It is therefore preferable for the thickness of the surface treatment layer to be not more than 1000 nm.

The stirring time for the slurry (c), which is particularly not limited, is normally not less than two minutes and not more than 60 minutes and preferably not less than five minutes and not more than thirty minutes.

After the mixing step is finished, the surface-treated phosphor formed in the solvent containing polyol is subjected to suction and filtration or another processing to be separated and collected from the solvent containing polyol. The collected surface-treated phosphor is properly dried, so that the surface-treated phosphor according to the embodiment is obtained.

The method of manufacturing a surface-treated phosphor according to the embodiment is a method of manufacturing a surface-treated phosphor including: an alkaline-earth silicate phosphor containing a silicate of alkaline-earth metal; and a surface treatment layer covering the surface of the alkaline-earth silicate phosphor. The manufacturing method includes the surface treatment step. In the surface treatment step, the alkaline-earth silicate phosphor and the surface treatment substance are brought into contact with each other. The surface treatment substance is at least one selected from the group consisting of a sulfate, a phosphate, a carbonate, a borate, a boric acid, a titanate, and a fluoride. The alkaline-earth silicate phosphor and surface treatment substance are brought into contact with each other in the presence of at least a kind of polyol selected from the group consisting of diols and triols. In the surface treatment step, therefore, the surface treatment layer is formed on the surface of the alkaline-earth silicate phosphor.

With the method of manufacturing a surface-treated phosphor according to the embodiment, it is possible to manufacture a surface-treated phosphor with high initial luminous efficiency and high long-term reliability.

Specifically, with the method of manufacturing a surface-treated phosphor according to the embodiment, the alkaline-earth silicate phosphor does not come into contact with water in the process of forming the surface treatment layer. This prevents initial deterioration in the alkaline-earth silicate phosphor due to contact with water.

With the method of manufacturing a surface-treated phosphor according to the embodiment, water is less likely to remain in the interface between the alkaline-earth silicate phosphor and surface treatment layer. This prevents deterioration in the alkaline-earth silicate phosphor over a long period of time.

With the method of manufacturing a surface-treated phosphor according to the embodiment, the reffractive index of the surface treatment layer is set between reffractive indices of the alkaline-earth silicate phosphor and translucent medium. The surface-treated phosphor according to the embodiment therefore has a light extraction efficiency higher than the case where the surface treatment layer is not formed, thus providing high luminous efficiency.

### [Surface-treated Phosphor]

The surface-treated phosphor according to the embodiment is manufactured using the above-described method of manufacturing a surface-treated phosphor. The surface-treated phosphor according to the embodiment includes: an alkaline-earth silicate phosphor containing a silicate of alkaline-earth metal; and a surface-treated layer covering the surface of the alkaline-earth silicate phosphor.

### <Alkaline-earth Silicate Phosphor>

The alkaline-earth silicate phosphor constituting the surface-treated phosphor according to the embodiment is the same as one described in the above-described method of manufacturing a surface-treated phosphor. The description thereof is omitted.

### <Surface Treatment Layer>

The surface treatment layer is composed of a sulfate, a phosphate, a borate, a boric acid, a titanate, or a fluoride of at least a kind of alkaline-earth metal selected from the group consisting of Sr, Ba, and Ca. These compounds are resistant to moisture, and the surface-treated phosphor is therefore resistant to moisture.

Examples of the sulfate of alkaline-earth metal include barium sulfate (BaSO_{4,} reffractive index: about 1.64) and strontium sulfate (SrSO₄, reffractive index: about 1.63). Examples of the phosphate of alkaline-earth metal include strontium phosphate (Sr₃(PO₄)₂, reffractive index: about 1.6). Examples of the carbonate of alkaline-earth metal include strontium carbonate (SrCO₃, reffractive index: about 1.5) and barium carbonate (BaCO₃, reffractive index: about 1.6). Examples of the borate of alkaline-earth metal include barium metaborate (BaB2O₄, reffractive index: about 1.6).

The aforementioned substances as the component of the surface treatment layer are water-resistant and improve the water resistance of the alkaline-earth silicate phosphor. Moreover, the reffractive index of the surface treatment layer containing the aforementioned substances is higher than the reffractive index of the translucent medium described later and is between the reffractive indices of the phosphor and translucent medium. In the case where the reffractive index of the surface treatment layer is between the reffractive indices of the phosphor and translucent medium, excitation light (primary light) radiated from an excitation source, such as an LED chip, is reflected less when the excitation light is incident on the surface treatment layer of the surface-treated phosphor from the translucent medium. Moreover, light emitted from the phosphor is reflected less when the emitted light exits from the phosphor to the translucent medium. It is therefore preferred that the reffractive index of the surface treatment layer is between the reffractive indices of the phosphor and translucent medium.

The thickness of the surface treatment layer constituting the surface-treated phosphor is normally not less than 5 nm and not more than 1000 nm, preferably not less than 10 nm and not more than 500 nm, more preferably not less than 20 nm and not more than 500 nm, and still more preferably not less than 40 nm and not more than 200 nm. The reasons therefor are described in the aforementioned method of manufacturing a surface-treated phosphor, and the description thereof is omitted.

The surface-treated phosphor according to the embodiment has high initial luminous efficiency and high long-term reliability.

Specifically, in the surface-treated phosphor according to the embodiment, the alkaline-earth silicate phosphor does not come into contact with water in the process of forming the surface treatment layer. This prevents initial deterioration in the alkaline-earth silicate phosphor due to contact with water.

With the method of manufacturing a surface-treated phosphor according to the embodiment, water is less likely to remain in the interface between the alkaline-earth silicate phosphor and the surface treatment layer. This prevents deterioration in the alkaline-earth silicate phosphor over a long period of time.

In the surface-treated phosphor according to the embodiment, the reffractive index of the surface treatment layer is set between reffractive indices of the alkaline-earth silicate phosphor and translucent medium. The surface-treated phosphor according to the embodiment therefore provides a light extraction efficiency and a luminous efficiency higher than those in the case where the surface treatment layer is not formed.

When the surface-treated phosphor according to the embodiment is irradiated with excitation light (primary light) from an excitation source such as an LED chip, the alkaline-earth silicate phosphor constituting a core of the surface-treated phosphor converts a part of the excitation light to longer wavelength light (secondary light). The secondary light is radiated out of the surface-treated phosphor through the surface treatment layer.

Hereinafter, the manufacturing method and properties of the surface-treated phosphor of the disclosure are specifically described below by taking phosphor samples shown below as examples. The disclosure is not limited to the sample examples.

### (Sample #1)

At first, a phosphor dispersion solution composed of 200 ml of ethylene glycol with 5 g of powder of europium-activated barium•strontium•orthosilicate phosphor ((Ba,Sr)₂SiO₄:Eu²⁺, λₚ = 528 nm) dispersed is prepared (the dispersion solution preparation step). A surface treatment substance-dissolved solution composed of 100 ml of ethylene glycol with 0.05 g of ammonium sulfate dissolved is prepared (the surface treatment substance-dissolved solution preparation step).

Next, 200 ml of the phosphor dispersion solution is added with 100 ml of the surface treatment substance-dissolved solution. The resultant is then stirred and mixed at 25°C for ten minutes using a magnetic stirrer (the mixing step).

The slurry obtained after the stirring and mixing is subjected to suction and filtration using filter paper, and the residue is collected. The collected residue is dried at 150°C for one hour. After the drying process, a surface-treated phosphor (Sample #1) is obtained, which includes a surface treatment layer composed of barium sulfate and strontium sulfate on the surface of the phosphor. The surface treatment layer of the surface-treated phosphor has a thickness of about 50 nm.

### (Sample #2)

In the process of Sample #2, the amount of ammonium sulfate dissolved in the process of Sample #1 is replaced with 0.2 g. The other process is the same as the process of Sample #1. The surface treatment layer of the surface-treated phosphor (Sample #2) has a thickness of about 120 nm.

### (Sample #3)

In the process of Sample #3, the amount of ammonium sulfate dissolved in the process of Sample #1 is replaced with 0.8 g. The other process is the same as the process of Sample #1. The surface treatment layer of the surface-treated phosphor (Sample #3) has a thickness of about 300 nm.

Surface-treated phosphors below (Samples #4 to #9) are experimentally produced as samples for comparison.

### (Sample #4)

Sample #4 is the same as (Ba,Sr)2SiO₄:Eu²⁺ phosphor used in the process of Sample #1. In other words, Sample #4 is not subjected to the surface treatment of the embodiment.

### (Sample #5)

In the process of Sample #5, 200 ml of ethylene glycol used in preparing the phosphor dispersion solution in the process of Sample #1 is replaced with 200 ml of ethanol, and 100 ml of ethylene glycol used in preparing the surface treatment substance-dissolved solution is replaced with 100 ml of ethanol.

The other process is the same as the process of Sample #1.

In the process of Sample #5, the surface treatment substance does not dissolve in ethanol as the solvent. The surface treatment layer is not formed on the surface of the europium-activated barium•strontium•orthosilicate phosphor.

### (Sample #6)

In the process of Sample #6, 200 ml of ethylene glycol used in preparing the phosphor dispersion solution in the process of Sample #1 is replaced with 200 ml of methanol, and 100 ml of ethylene glycol used in preparing the surface treatment substance-dissolved solution is replaced with 100 ml of methanol.

In the process of Sample #6, the surface treatment substance does not dissolve in the methanol as the solvent. The surface treatment layer is not formed on the surface of the europium-activated barium•strontium•orthosilicae phosphor.

### (Sample #7)

In the process of Sample #7, 200 ml of ethylene glycol used in preparing the phosphor dispersion solution in the process of Sample #1 is replaced with 200 ml of isopropanol (IPA), and 100 ml of ethylene glycol used in preparing the surface treatment substance-dissolved solution is replaced with 100 ml of IPA.

In the process of Sample #7, the surface treatment substance does not dissolve in IPA as the solvent. The surface treatment layer is not formed on the surface of the europium-activated barium•strontium•orthosilicate phosphor.

### (Sample #8)

In the process of Sample #8, 200 ml of ethylene glycol used in preparing the phosphor dispersion solution in the process of Sample #1 is replaced with 200 ml of water, and 100 ml of ethylene glycol used in preparing the surface treatment substance-dissolved solution is replaced with 100 ml of water. In the resultant surface treatment phosphor (Sample #8), part of the surface of the (Ba,Sr)₂SiO₄:Eu²⁺ phosphor is not covered with the surface treatment layer, and the thickness of the surface treatment layer varies within a range from 0 to 5 nm.

### (Sample #9)

At first, 0.05 g of ammonium sulfate is dissolved in 200 ml of water to prepare ammonium sulfate aqueous solution. Next, 200 ml of the prepared ammonium sulfate aqueous solution is added with 5 g of powder of (Ba,Sr)₂SiO₄:Eu²⁺ phosphor. In this case, the phosphor aggregates. The resultant mixture including the aggregated phosphor is stirred and mixed at 25°C for 10 minutes using a magnetic stirrer. The aggregated phosphor is reduced but is still visually recognized.

The resultant slurry obtained after the stirring and mixing is subjected to suction and filtration using filtration paper, and the residue is collected. The collected residue is dried at 150°C for one hour. After the drying process, a surface-treated phosphor is obtained, in which a surface treatment layer composed of barium sulfate and strontium sulfate is formed on the surface of the phosphor. In the resultant surface treatment phosphor (Sample #9), part of the surface of the (Ba,Sr)₂SiO₄:Eu²⁺ phosphor is not covered with the surface treatment layer, and the thickness of the surface treatment layer varies within a range from 0 to 60 nm.

Table 1 shows the production conditions, the thickness of the surface treatment layer, the initial luminous efficiency, and the moisture resistance of Samples #1 to #9 described above.

**(Table 1)**

| | SURFACE TREATMENT SUBSTANCE | SOLVENT OF SURFACE TREATMENT SUBSTANCE | THICKNESS OF SURFACE TREATMENT LAYER (nm) | RELATIVE VALUE OF INITIAL LUMINOUS EFFICIENCY (-) | RELATIVE VALUE OF LUMINOUS EFFICIENCY AFTER MOISTURE RESISTANCE TEST (-) | NOTE |
|---|---|---|---|---|---|---|
| #1 | Ammonium Sulfate | Ethylene Glycol | 50 | 104 | 97 | |
| #2 | Ammonium Sulfate | Ethylene Glycol | 120 | 104 | 97 | |
| #3 | Ammonium Sulfate | Ethylene Glycol | 300 | 104 | 99 | |
| #4 | - | - | - | 100 | 68 | No Surface Treatment |
| #5 | Ammonium Sulfate | Ethanol | - | - | - | Surface Treatment Layer is Not Formed |
| #6 | Ammonium Sulfate | Methanol | - | - | - | Surface Treatment Layer is Not Formed |
| #7 | Ammonium Sulfate | IPA*1 | - | - | - | Surface Treatment Layer is Not Formed |
| #8 | Ammonium Sulfate | Water | 0-5 (Partially Uncovered) | 84 | 74 | |
| #9 | - | Water | 0-5 (Partially Uncovered) | 99 | 88 | Phosphor is Aggregated |

| | | | | | | |
|---|---|---|---|---|---|---|
| *1: isopropyl alcohol | | | | | | |

### (Initial Luminous Efficiency)

Generally, the luminous efficiency (Im/W) of a phosphor can be measured using a spectrofluorometer (product name: QE-1100, half moon-type integrating sphere, made by OTSUKA ELECTRONICS Co., LTD.). The measurement conditions are as follows: the excitation wavelength is 450 nm; the measurement wavelength range is not less than 460 and not more than 800 nm; and the number of scans is 30. The initial luminous efficiency of Samples #1 to #5 and #7 is expressed as relative values with the luminous efficiency (Im/W) of Sample #6 being 100.

Table 1 shows that the initial luminous efficiencies of Samples #1 to #3, each including the surface treatment layer, are 3 to 4% higher than Sample #4, which is not subjected to surface treatment.

### (Moisture Resistance)

In evaluation of the moisture resistance, the luminous efficiency is measured after Samples #1 to #4, #8, and #9 are subjected to hygroscopic treatment shown below. In the hygroscopic treatment, at first, 1 L of water in which 1 g of powder of each sample is dispersed is stirred for 20 minutes. Next, the dispersion solution is filtrated, and the residue is dried at 150°C for one hour, thus preparing samples for moisture resistance tests.

The initial luminous efficiency of each sample for moisture resistance tests is expressed as relative values with the luminous efficiency (Im/W) of Sample #4 (not subjected to hygroscopic treatment) being 100.

Table 1 shows that the relative luminous efficiencies of Samples #1 to #3, each including the surface treatment layer, and Samples #8 and #9, in which the surface treatment layer is partially formed, are 29 to 31% higher than the relative luminous efficiency of Sample #4, which is not subjected to the surface treatment.

From the aforementioned results, Samples #1 to #3, each including the surface treatment layer, are more excellent in initial luminous efficiency and moisture resistance than Sample #4, which is not subjected to the surface treatment.

The disclosure has been described by reference to the samples produced experimentally. The disclosure is not limited to those descriptions, and it will be apparent to those skilled in the art that various modifications and improvements can be made.

Light emission of the surface-treated phosphor requires an excitation source such as an LED chip. A description is given of a wavelength conversion member including the surface-treated phosphor and a light emission device composed of the wavelength conversion member and an excitation source.

### [Wavelength Conversion Member]

A wavelength conversion member according to the embodiment includes a translucent medium and a surface-treated phosphor dispersed in the translucent medium. In the wavelength conversion member, the surface-treated phosphor is the surface-treated phosphor according to the aforementioned embodiment. The translucent medium has a refractive index smaller than the surface treatment layer of the surface-treated phosphor.

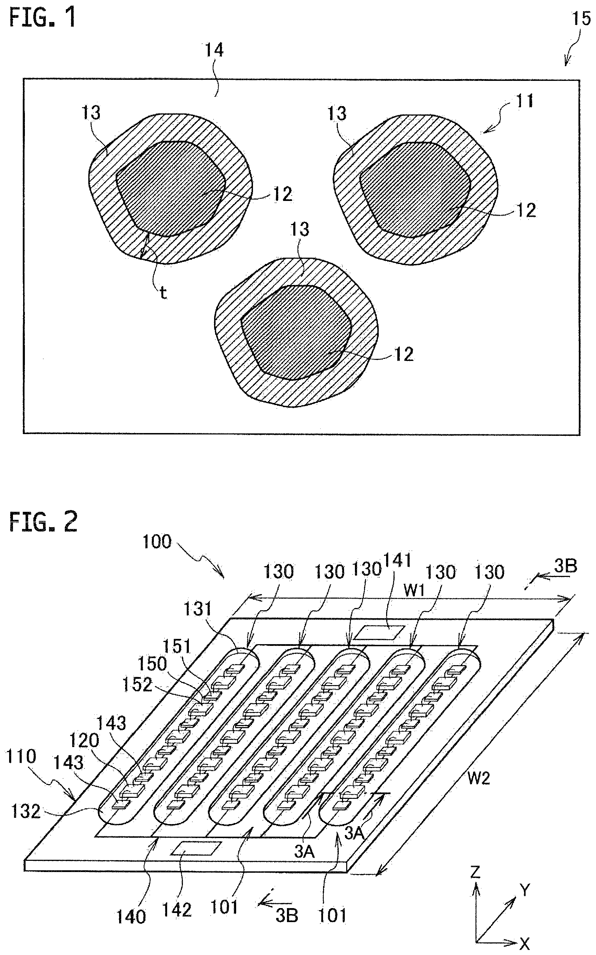

Hereinafter, a description is given of the specific configuration of the wavelength conversion member of the embodiment with reference to the drawing. FIG. 1 is a schematic view illustrating a surface-treated phosphor 11 and a wavelength conversion member 15 according to the embodiment of the disclosure.

In the wavelength conversion member 15, the surface-treated phosphor 11 is dispersed in a translucent medium 14. The surface-treated phosphor 11 includes an alkaline-earth silicate phosphor 12 and the surface treatment layer 13 covering the surface of the alkaline-earth silicate phosphor 12. In FIG. 1, reference symbol t indicates the thickness of the surface treatment layer 13.

### (Surface-treated Phosphor)

The surface-treated phosphor 11 is the same as the surface-treated phosphor according to the aforementioned embodiment, and the description thereof is omitted.

### (Translucent Medium)

The translucent medium 14 has translucency. In the translucent medium 14, the surface-treated phosphor 11 is dispersed. The translucent medium 14 is normally a translucent medium having a refractive index smaller than the refractive index of the surface treatment layer 13 of the surface-treated phosphor 11. In the case where the refractive index of the translucent medium is set smaller than that of the surface treatment layer 13 of the surface-treated phosphor 11, excitation light (primary light), which is radiated from the excitation source, such as an LED chip, is reflected less when the excitation light is incident on the surface treatment layer 13 of the surface-treated phosphor 11. Moreover, when light is emitted out of the surface-treated phosphor 11 to the translucent medium 14, the emitted light is reflected less. It is therefore preferable for the refractive index of the translucent medium to be set smaller than that of the surface treatment layer 13 of the surface-treated phosphor 11.

The translucent medium 14 is a silicate compound including a siloxane bond, glass, acrylic resin, an organic-inorganic hybrid material formed by mixing and combining organic and inorganic components at nanometer level or molecular level, or the like. Among such translucent media, the silicate compound including a siloxane bond and glass are excellent in resistance to heat and light and are particularly excellent in durability to short-wavelength light, including blue to ultraviolet light. These materials are less likely to deteriorate even when the excitation light (primary light) radiated from the excitation source, such as an LED chip, has a range of wavelength of blue to ultraviolet light.

Examples of the silicate compound are silicone resin, hydrolytic condensation products of organosiloxane, condensation products of organosiloxane, and composite resin cross-linked by a publicly-known polymerization method. The publicly-known polymerization method is addition polymerization such as hydrosilylation, radical polymerization, or the like.

The method of dispersing the surface-treated phosphor 11 in the translucent medium 14 is a method that uniformly disperses the surface-treated phosphor 11 in the translucent medium 14 in a fluidized state and then hardens the fluidized translucent medium, for example.

The wavelength conversion member 15 has a structure in which the surface-treated phosphor 11 is dispersed in the translucent medium 14. When excitation light (primary light) from an excitation source is incident on the wavelength conversion member 15, a part of the excitation light is converted to longer wavelength light (secondary light). The secondary light is radiated out of the wavelength conversion member 15 through the translucent medium 14.

The wavelength conversion member 15 according to the embodiment has high initial luminous efficiency and high long-term reliability.

### <Light Emission Device>

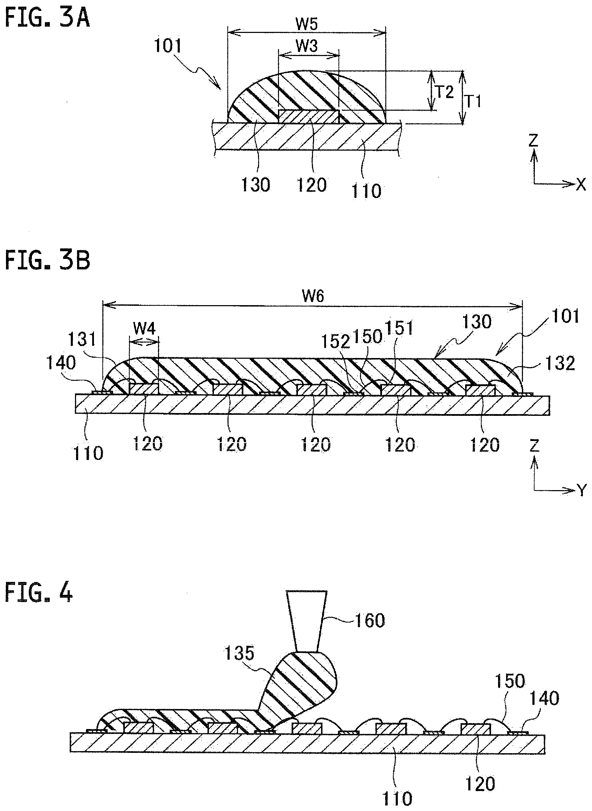

A description is given of a semiconductor light emission device 100 as an example of the light emission device of the embodiment with reference to FIGS. 2 to 4. FIG. 2 is a perspective view of the semiconductor light emission device 100. FIG. 3A is a cross-sectional view along a line 3A-3A in FIG. 2, and FIG. 3B is a cross-sectional view along a line 3B-3B in FIG. 4. FIG 4 is a view for explaining a method of forming a sealing member in the semiconductor light emission device 100.

As illustrated in FIG. 2, the semiconductor light emission device 100 is a light emission device including plural LEDs 120 as excitation sources and a surface-treated phosphor which converts a part of light radiated from the excitation sources to longer-wavelength light and radiates the same. The semiconductor light emission device 100 further includes a substrate 110 and plural sealing members 130 including the surface-treated phosphor. The substrate 110 has a two-layer structure composed of an insulating layer made of ceramic, thermally-conductive resin, or the like and a metal layer made of an aluminum plate or the like. The substrate 110 has a square-plate profile as a whole. The substrate 110 has a width W1 of 12 to 30 mm in the short-side direction (in the X-axis direction) and a width W2 of 12 to 30 mm in the longitudinal direction (in the Y-axis direction).

As illustrated in FIGS. 3A and 3B, each LED 120 has a rectangular profile in a plan view as a whole. Each LED 120 is a GaN-based LED having a peak wavelength of 440 to 500 nm, for example. Each LED 120 has a width W3 of 0.3 to 1.0 mm in the short-side direction (in the X-axis direction), a width W4 of 0.3 to 1.0 mm in the longitudinal direction (in the Y-axis direction), and a thickness (width in the Z-axis direction) of 0.08 to 0.30 mm.

In the arrangement of the plural LEDs 120, the longitudinal direction (the Y-axis direction) of the substrate 110 corresponds to the direction of device rows of the LEDs 120. The plural LEDs 120 arranged in line in the longitudinal direction of the substrate 110 constitute each device row. The plural device rows are arranged side by side in the short-side direction (in the X-axis direction) of the substrate 110. Specifically, in 25 LEDs 120, five device rows each composed of five LEDs are arranged side by side, for example. When the LEDs 120 are arranged in line, the sealing members 130, sealing the LEDs 120, can be formed in a linear manner.

As illustrated in FIG 3B, the device rows are individually sealed by the respective long sealing members 130. One of the device rows and one of the sealing members sealing the same device row constitute each light emitting section 101. The semiconductor light emission device 100 includes five light emitting sections 101.

The sealing members 130 are made of a translucent resin material containing a phosphor. The resin material can be silicone resin, fluorine resin, silicone epoxy hybrid resin, urea resin, or the like, for example. The phosphor converts a part of light radiated from the LEDs 120 to longer wavelength light and radiates the same. The sealing members 130 containing the phosphor serve as the wavelength conversion member. Herein, the phosphor can be the surface-treated phosphor of the embodiment. In addition to the surface-treated phosphor of the embodiment, the phosphor can be an oxide-based phosphor such as an oxide and an acyl halide activated by at least any one of Eu²⁺, Ce³⁺, Tb³⁺, and Mn²⁺. In addition to the surface-treated phosphor of the embodiment, the phosphor can be a nitride-based phosphor such as a nitride and an oxynitride activated by at least any one of Eu²⁺, Ce³⁺, Tb³⁺, and Mn²⁺ or a sulfide-based phosphor such as a sulfide or an oxysulfide.

Concrete examples of the phosphor used in the surface-treated phosphor of the embodiment are shown below. Examples of blue phosphors include BaMgAl₁₀O₁₇:Eu²⁺, CaMgSi₂O₆:Eu²⁺, Ba₃MgSi₂O₈: Eu²⁺, Sr10(PO₄)₆Cl₂:Eu²⁺, and the like. Examples of green blue or blue green phosphors include Sr₄Si₃O₈Cl₄:Eu²⁺, Sr₄Al₁₄O₂₄:Eu²⁺, BaAl₈O₁₃:Eu²⁺, and Ba₂SiO₄:Eu²⁺. Examples of green blue or blue green phosphors further include BaZrSi₃O₉:Eu²⁺, Ca₂YZr₂(AlO₄)₃:Ce³⁺, Ca₂YHf₂(AlO₄)₃:Ce³⁺, and Ca₂YZr₂(AlO₄)₃:Ce³⁺,Tb³⁺. Examples of green phosphors include (Ba,Sr)₂SiO₄:Eu²⁺, Ca₈Mg(SiO₄)₄Cl₂:Eu²⁺, and Ca₈Mg(SiO₄)₄Cl₂:Eu²⁺,Mn²⁺. Examples of green phosphors further include BaMgAl₁₀O₁₇:Eu²⁺,Mn²⁺, CeMgAl₁₁O₁₉:Mn²⁺, Y₃Al₂(AlO₄)₃:Ce³⁺, and Lu₃Al₂-(AlO₄)_{3:}Ce3+. Examples of green phosphors still further include Y₃Ga₂(AlO₄)₃:Ce³⁺, Ca₃Sc₂Si₃O₁₂:Ce³⁺, CaSc₂O₄:Ce3+, β-Si₃N₄:Eu2+, and SrSi₂O₂N₂:Eu2+. Examples of green phosphors still further include Ba₃Si₆O₁₂N₂:Eu²⁺, Sr₃Si₁₃Al₃O₂N₂₁:Eu²⁺, YTbSi₄N₆C:Ce³⁺, and SrGa₂Sa:Eu²⁺. Examples of green phosphors still further include Ca₂LaZr₂(AlO₄)₃:Ce³⁺, Ca₂TbZr₂(AlO₄)₃:Ce³⁺, and Ca₂TbZr₂(AlO₄)₃:Ce³⁺,Pr³⁺. Examples of green phosphors still further include Zn₂SiO₄:Mn²⁺ and MgGa₂O₄:Mn²⁺. Examples of green phosphors still further include LaPO₄:Ce³⁺,Tb³⁺, Y₂SiO₄:Ce³⁺, CeMgAl₁₁O₁₉:Tb³⁺, and GdMgB₅O₁₀:Ge³⁺,Tb³⁺. Examples of yellow or orange phosphor include (Sr,Ba)₂SiO₄:Eu²⁺, (Y,Gd)₃Al₅O₁₂:Ce³⁺, and α-Ca-SiAlON:Eu²⁺. Examples of yellow or orange-color phosphors include Y₂Si₄N₆C:Ce³⁺, La₃Si₆N₁₁:Ce³⁺, and Y₃MgAl(AlO₄)₂(SiO₄):Ce³⁺. Examples of red phosphors include Sr₂Si₅N₈:Eu²⁺, CaAlSiN₃:Eu²⁺, SrAlSi₄N₇:Eu²⁺, CaS:Eu²⁺, La₂O₂S:Eu³⁺, and Y₃Mg₂(AlO₄)(SiO₄)₂:Ce³⁺. Examples of red phosphors include Y₂O₃:Eu³⁺, Y₂O₂S:Eu³⁺, Y(P,V)O₄:Eu3+, and YVO₄:Eu3+. Examples of red phosphors include 3.5MgO•0.5MgF₂•GeO₂:Mn⁴⁺, K₂SiF₆:Mn⁴⁺, and GdMgB₅O₁₀:Ce³⁺,Mn²⁺.

As illustrated in FIG. 4, the sealing members 130 are preferably long and thin. Specifically, the sealing member 130 preferably has a width W5 of 0.8 to 3.0 mm in the short-side direction (in the X-axis direction) and a width W6 of 3.0 to 40.0 mm in the longitudinal direction (in the Y-axis direction). Preferably, the maximum thickness (width in the Z-axis direction) T1 of the sealing member 130 including the LEDs 120 is preferably 0.4 to 1.5 mm while the maximum thickness T1 not including the LEDs 120 is 0.2 to 1.3 mm. To ensure sealing reliability, the width W5 of the sealing members 130 is preferably two to seven times the width W3 of the LEDs 120.

The cross-section of each sealing member 130 in the short-side direction has a semi-elliptic profile as illustrated in FIG. 3A. Both ends 131 and 132 of the sealing member 130 in the longitudinal direction are round. Specifically, the plan view of each end 131 and 132 has a semicircular shape as illustrated in FIG. 2. The cross-sectional shape thereof in the longitudinal direction is a sector having a central angle of about 90° as illustrated in FIG. 3B. When the ends 131 and 132 of the sealing member 130 are round as described above, the ends 131 and 132 are less subject to stress concentration, and light emitted from the LEDs 120 is easily extracted out of the sealing member 130.

Each LED 120 is mounted on the substrate 110 facing up. The LEDs 120 are electrically connected to a lighting circuit (not illustrated) through a wiring pattern 140 formed on the substrate 110. The wiring pattern 140 includes a pair of power supply lands 141 and 142 and plural bonding lands 143 located at positions corresponding to the respective LEDs 120.

As illustrated in FIG. 4, the LEDs 120 are electrically connected to the lands 143 through wires (gold wires, for example) 150, for example. An end 151 of each wire 150 is bonded to one of the LEDs 120, and the other end 152 is bonded to one of the lands 143. The wires 150 are arranged in the direction of the device rows. The wires 150 are sealed in the sealing members 130 together with the LEDs 120 and lands 143 and are less likely to deteriorate. The wires 150 are insulated by the sealing members 130. The method of mounting the LEDs 120 on the substrate 110 is not limited to face-up mounting as described above and may be flip-chip mounting.

In the LEDs 120, as illustrated in FIG. 2, five LEDs 120 located in the same device row are connected in series, and five device rows are connected in parallel. The connection of the LEDs 120 is not limited to the above-described connection, and the LEDs 120 may be connected in any fashion regardless of device rows. The lands 141 and 142 are connected to a pair of leads (not illustrated), and electric power is supplied to each LED 120 from a lighting circuit unit through the leads.

The sealing member 130 can be formed by the following procedure. On the substrate 110 on which the LEDs 120 are mounted in line, resin paste 135 is applied in the linear manner along the device rows using a dispenser 160, for example. The applied resin paste 135 is then solidified to form the sealing members 130 separately for the respective device rows.

The semiconductor light emission device of the embodiment can be widely used for illumination light sources, backlights of liquid crystal displays, light sources of display devices, and the like.

An illumination light source includes the semiconductor light emission device of the embodiment, a lighting circuit configured to supply electric power to the semiconductor light emission device, and a cap as a connector for light fixtures. The light fixtures are properly combined to constitute lighting apparatuses and systems. The light source employing the semiconductor light emission device of the embodiment has high initial luminous efficiency and high long-term reliability.

In the semiconductor light emission device 100, the LEDs are used as the excitation source. However, the excitation source is not limited to the LEDs and, in the light emission device according to the disclosure, can be properly selected from discharge devices, electron guns, solid light emitting devices, and the like.

The semiconductor light emission device 100 is an example in which the excitation source is embedded in the wavelength conversion member (the sealing members 130) including the surface-treated phosphor. In the light emission device according to the disclosure, the excitation source and wavelength conversion member may be separately arranged.

### REFERENCE SIGN LIST

11 SURFACE-TREATED PHOSPHOR
12 ALKALINE-EARTH SILICATE PHOSPHOR (EUROPIUM-ACTIVATED BARIUM•STRONTIUM•ORTHOSILICATE PHOSPHOR PARTICLES)
13 SURFACE TREATMENT LAYER
14 TRANSLUCENT MEDIUM
15 WAVELENGTH CONVERSION MEMBER

## Claims

1. A method of manufacturing a surface-treated phosphor in which the surface of an alkaline-earth silicate phosphor containing a silicate of alkaline-earth metal is covered with a surface treatment layer, the method comprising:
surface treatment which brings the alkaline-earth silicate phosphor and a surface treatment substance into contact in the presence of at least a kind of polyol selected from the group of diols and triols to form the surface treatment layer on the surface of the alkaline-earth silicate phosphor, the surface treatment substance being at least one selected from the group consisting of a sulfate, a phosphate, a carbonate, a borate, a boric acid, a titanate, and a fluoride.

2. The method of manufacturing a surface-treated phosphor according to claim 1, wherein
the surface treatment includes:
dispersion solution preparation which disperses the alkaline-earth silicate phosphor in a solvent containing the polyol to prepare a phosphor dispersion solution (A);
surface treatment substance-dissolved solution preparation which dissolves the surface treatment substance in a solvent containing the polyol to prepare a surface treatment substance-dissolved solution (B); and
mixing which mixes the phosphor dispersion solution (A) and the surface treatment substance-dissolved solution (B).

3. The method of manufacturing a surface-treated phosphor according to claim 1 or 2, wherein
the surface treatment layer has a thickness of not less than 5 nm and not more than 1000 nm.

4. The method of manufacturing a surface-treated phosphor according to any one of claims 1 to 3, wherein
the silicate of the alkaline-earth metal is a silicate of at least a kind of alkaline-earth metal selected from strontium, barium, and calcium.

5. A surface-treated phosphor manufactured by using the method of manufacturing a surface-treated phosphor according to any one of claims 1 to 4.

6. A wavelength conversion member, comprising:
a translucent medium; and
the surface-treated phosphor according to claim 5 dispersed in the translucent medium, wherein
the translucent medium has a refractive index smaller than the surface treatment layer of the surface-treated phosphor.

7. A light emission device, comprising:
an excitation source; and
the surface-treated phosphor according to claim 5 which converts a part of light radiated from the excitation source to light of longer wavelength and radiates the light of longer wavelength.

8. Alight emission device, comprising:
an excitation source; and
the wavelength conversion member according to claim 6 which converts a part of light radiated from the excitation source to light of longer wavelength and radiates the light of longer wavelength.
